# EUROPÄISCHE PATENTSCHRIFT

(11) **EP 2 729 426 B1**
(45) Veröffentlichungstag und Bekanntmachung des Hinweises auf die Patenterteilung: **08.04.2020**
(21) Anmeldenummer: 12735492.6
(22) Anmeldetag: 04.07.2012
(51) Int. Cl.: C03C 4/12, H01L 33/50, C03C 17/00, C03C 23/00, C03C 14/00

(54) **VERFAHREN ZUR HERSTELLUNG EINES KONVERSIONSELEMENTS UND KONVERSIONSELEMENT**
METHOD FOR PRODUCING A CONVERSION ELEMENT, AND CONVERSION ELEMENT
PROCÉDÉ DE PRODUCTION D'UN ÉLÉMENT DE CONVERSION, ET ÉLÉMENT DE CONVERSION

(30) Priorität: 05.07.2011 DE 102011078663
(43) Veröffentlichungstag der Anmeldung: 14.05.2014
(73) Patentinhaber: OSRAM GmbH, 80807 München (DE)
(72) Erfinder: EBERHARDT, Angela, 86157 Augsburg (DE); SCHMIDT, Reinhold, 86179 Augsburg (DE); STRIXNER, Harald, 86507 Oberottmarshausen (DE)
(74) Vertreter: Epping - Hermann - Fischer
(86) Internationale Anmeldenummer: PCT/EP2012/063011
(87) Internationale Veröffentlichungsnummer: WO 2013/004735

(56) Entgegenhaltungen:
- WO-A1-2010/110204
- WO-A1-2011/035475
- GB-A- 606 819
- US-A1- 2011 143 627

## Beschreibung

Die Erfindung betrifft ein Verfahren zur Herstellung eines Konversionselements und ein Konversionselement. Konversionselemente dienen in Verbindung mit optischen oder optoelektronischen Bauelementen dazu, das Spektrum und somit den wahrgenommenen Farbeindruck der durch das Bauelement abgegebenen elektromagnetischen Strahlung zu verändern. Ein Konversionselement wird dazu vor dem Bauelement, etwa einem lichtemittierenden Halbleiterchip so angebracht, dass die vom Bauelement abgegebene Strahlung durch das Konversionselement hindurchtritt. Leuchtstoffe im Konversionselement stellen dabei den Farbort und die Farbtemperatur ein.

Herkömmlich werden bei der Herstellung eines Konversionselements das Matrixmaterial und der Leuchtstoff miteinander vermischt. Als Matrixmaterial wird herkömmlich Silikon verwendet, in welches der Leuchtstoff suspendiert wird. Die Suspension wird dann als dünne Schicht auftragen, beispielweise durch Siebdruck. Silikon ist allerdings ein schlechter Wärmeleiter und vermag während des Betriebs des lichtemittierenden Bauelements die entstehende Wärme nur unzureichend abzuleiten, weshalb der Leuchtstoff dann einer erhöhten thermischen Belastung ausgesetzt ist und deshalb an Effizienz verliert.

Glas als Matrixmaterial hat den Vorteil der besseren Wärmeleitung, da diese im Vergleich zu Silikon im Schnitt um den Faktor 10 höher ist, wodurch sich die Leuchtstoffe im Betrieb weniger erwärmen und dadurch effizienter sind. Andererseits sind bei der Verwendung von Glas als Matrix hohe Temperaturen zum Einbetten der Leuchtstoffpartikel notwendig, wodurch der Leuchtstoff bei diesem Prozess geschädigt werden und so ebenfalls dauerhaft an Effizienz verlieren kann.

DE 10 2008 021 438 A1 beschreibt ein Verfahren zur Herstellung eines Konversionselements mit Glasmatrix, bei dem eine Pulvermischung aus Glas und Leuchtstoff vermischt, verdichtet und versintert wird. Bei diesem Sinterverfahren werden relativ hohe Temperaturen (150 °C oberhalb der Erweichungstemperatur) verwendet.

Die Druckschriften WO 2011/035475 A1 & EP 2 481 571 A1 offenbaren ein lumineszierendes Glas umfassend eine Glasmatrix mit darin dispergiertem fluoreszierenden Pulver.

Es ist die Aufgabe der vorliegenden Erfindung, ein Konversionselement und ein Verfahren zu seiner Herstellung bereitzustellen, mit denen die optischen Eigenschaften des Konversionselements verbessert und insbesondere Glasmaterialien als Matrixmaterial für ein Konversionselement einsetzbar werden, bei dem der Leuchtstoff möglichst wenig oder nicht geschädigt wird. Gegenüber den handelsüblichen Konversionselementen, die Silikon als Matrixmaterial enthalten, soll eine verbesserte Wärmeableitung während des Betriebs des Konversionselements erreicht werden.

Diese Aufgabe wird durch ein Verfahren gemäß Anspruch 1 und durch ein Konversionselement gemäß Anspruch 9 gelöst. Bei dem Verfahren nach Anspruch 1 wird der Leuchtstoff nicht in Silikon, sondern in ein Glasmaterial eingebracht, da Glas im Vergleich zu Silikon eine besonders hohe Wärmeableitung gewährleistet. Vor allem aber wird der Leuchtstoff nicht schon zu Beginn des Herstellungsverfahrens mit dem Matrixmaterial (hier mit dem Glas) vermengt. Insbesondere wird vermieden, eine Materialmischung aus Leuchtstoff und Matrixmaterial (Pulver gemäß DE 10 2008 021 438 A1 oder Schmelze) einer Temperaturbehandlung zu unterziehen. Stattdessen wird ein Glasmaterial in kompakter Form verwendet; wahlweise als vorgeformtes Substrat oder als erweichte Glasmasse. In das erweichte Glasmaterial wird der Leuchtstoff erst nachträglich eingebracht.

Würde man eine Materialmischung aus Glaspartikeln und Leuchtstoffpartikeln direkt dem Temperaturbehandlungsschritt aussetzen, der zum Schmelzen und Verglasen der Materialmischung führt, wäre der Leuchtstoff einer sehr starken Temperaturbelastung (bei hoher Temperatur und/oder über eine lange Zeitdauer) ausgesetzt. Eine der in dieser Anmeldung ausgenutzten Überlegungen besteht jedoch darin, dass dann, wenn eine Glasmasse bereits als zusammenhängender Glaskörper vorliegen würde, keine Wärmeenergie mehr für das Zusammenschmelzen der Glaspartikel zu einer möglichst blasenarmen Glasmasse mehr erforderlich wäre. Erfindungsgemäß wird daher der Leuchtstoff nicht schon zu Beginn der Herstellung mit Glasmaterial vermischt, sondern es wird zunächst ein leuchtstofffreies Glasmaterial verwendet, das zunächst nur auf seiner Oberfläche (etwa seiner Oberseite) mit Leuchtstoff oder einem leuchtstoffhalten Material bedeckt wird. Das Eintreiben des Leuchtstoffs in das Glasmaterial erfolgt dann nachträglich durch Einsinken bei erhöhter Temperatur. Dabei wird das Glas - im Gegensatz zu dem Sinterverfahren aus DE 10 2008 021 438 A1 - nur soweit erwärmt, dass der Leuchtstoff in dessen Oberfläche einsinkt. Die zum Erhalt eines blasenarmen Konversionselements erforderlichen Temperaturen sind hier bei gleichen Prozessbedingungen (Zeitdauer) bei Normaldruck (1013 mbar) niedriger als bei dem Sinterverfahren. Das Glas kann als festes Glassubstrat, das noch aufzuheizen ist, oder als bereits erhitzte und dadurch erweichte Glasmasse (in einer Press- oder Gussform) bereitgestellt werden.

Der Leuchtstoff oder die leuchtstoffhaltige Schicht wird zunächst auf eine Außenseite (etwa Oberseite) der Glasschicht oder des Glassubstrats aufgebracht und dann erst nachträglich durch Einsinken in das homogene Glasmaterial eingebracht. Aufgrund der niedrigeren Temperatur im Vergleich zu dem in DE 10 2008 021 438 A1 beschriebenen Sinterverfahren ist deshalb des Risiko einer herstellungsbedingten Schädigung des Leuchtstoffs geringer. Dies erhöht somit die Einsetzbarkeit von Glasmaterialien als Alternative zu Silikon in Konversionselementen.

Das Glasmaterial bildet nicht lediglich eine Unterlage zum Aufbringen des Leuchtstoffs oder der leuchtstoffhaltigen Schicht, sondern es dient als eigentliches Grundmaterial für das Konversionselements selbst, denn der Leuchtstoff wird durch das Einsinken unmittelbar in das Glasmaterial eingebracht. Der Einsinkvorgang kann durch Ausnutzung der Erdanziehungskraft, durch mechanisches Pressen und/oder durch Überdruck unterstützt und beschleunigt werden, jeweils in Verbindung mit der Wärmeeinwirkung während der Temperaturbehandlung. Das transparente Glassubstrat wird dabei über seine Erweichungstemperatur hinaus erhitzt. Das fertige Konversionselement enthält später eingesunkene Leuchtstoffpartikel einer Leuchtstoffart bzw. einer Mischung verschiedener Leuchtstoffarten in dem als Matrix verwendeten Glasmaterial.

Das Glasmaterial kann vor Durchführung der Temperaturbehandlung bei Raumtemperatur bereitgestellt und gemeinsam mit der oben aufgebrachten leuchtstoffhaltigen Schicht erhitzt werden. Die Glasmasse wird dabei erneut erweicht, jedoch nur soweit, dass der Leuchtstoff in diese einsinkt.

Alternativ kann die Temperaturbehandlung des Glasmaterials eingeleitet werden, bevor der Leuchtstoff auf die Oberfläche des erhitzten und erweichten Glasmaterials aufgebracht wird. Wird das Glas beispielsweise aus Glaspulver oder aus der Schmelze hergestellt, so erfolgt die Beschichtung mit Leuchtstoff erst nach der Abkühlung des so erhaltenen blasenarmen Glaskörpers. Alternativ kann die Beschichtung mit Leuchtstoff und das Einsinken des Leuchtstoffs auch während der Abkühlphase bei einer Temperatur oberhalb der Erweichungstemperatur (ggfs. unterstützt durch mechanisches Pressen oder Überdruck) erfolgen. Gemäß ISO 7884-3 ist die Erweichungstemperatur mit einer Viskosität η = 10^{7,8} dPa·s definiert. Die hier beschriebene Alternative kombiniert Glasformung, Beschichtung und Einsinken in einen Prozess und erspart das ansonsten nochmals erforderliche Aufheizen, um das Glas zu erweichen. Ebenso können auch bereits fertig geformte oder kommerziell erhältliche Glaskörper wie beispielsweise planparalleles Dünnglas, Ultradünnglas, Linsen (konkav, konvex usw.) oder Kolben für die Herstellung eines derartigen Konversionselements verwendet werden. In diesem Fall wird der Glaskörper mit Leuchtstoff beschichtet und dann nur soweit erwärmt, dass der Leuchtstoff in die Glasoberfläche einsinkt.

Der Zeitpunkt, zu dem der Leuchtstoff bzw. das leuchtstoffhaltige Material auf die Oberfläche des Glasmaterials aufgebracht wird, kann wahlweise vor oder während der Temperaturbehandlung gewählt werden; die zeitliche Abfolge ist flexibel, hängt allerdings davon ab, durch welches Verfahren der Leuchtstoff aufgebracht wird, sowie von der Zusammensetzung des leuchtstoffhaltigen Materials. Wird das leuchtstoffhaltige Material beispielsweise als druckfähige Paste (etwa für Sieb- und Schablonendruck) aufgebracht, so beinhaltet die Paste neben den Leuchtstoffpartikeln in der Regel auch noch ein Lösemittel und einen Binder. In diesem Fall erfolgt die Beschichtung des Glassubstrats vorzugsweise vor der Erwärmung, sodass das Verdampfen des Lösemittels sowie der Binderausbrand während des Aufheizvorgangs erfolgen können. Das leuchtstoffhaltige Material kann auch durch Aufsprühen, Aufpinseln oder Aufstreichen, durch elektrostatisches Abscheiden oder auf andere Weise auf das Glas aufgebracht werden. Das leuchtstoffhaltige Material kann den Leuchtstoff in einem organischen Lösungsmittel (etwa Isopropanol) suspendiert enthalten.

Als Glas können Weichgläser oder Hartgläser verwendet werden. Ferner ist auch die Verwendung niederschmelzender Gläser möglich. Als Weichglas eignet sich beispielsweise das Borosilikatglas der Bezeichnung D263T des Herstellers Schott, das als Dünnglas erhältlich ist. Je nach Wahl des Glases kann die Temperatur, die bei der Temperaturbehandlung gehalten oder zumindest kurzzeitig maximal erreicht wird, zwischen 80 °C und 1500 °C liegen. Vorzugsweise werden Gläser verwendet, deren Erweichungstemperatur nicht höher ist als 740 °C, damit der Leuchtstoff noch bei Temperaturen unterhalb von 800 °C zum Einsinken in die Glasoberfläche gebracht werden kann (ggfs. unter Zuhilfenahme mechanischen Pressens oder durch Überdruck). Beispielsweise können Hartgläser oder Weichgläser mit einer Erweichungstemperatur von zwischen 600 und 950 °C eingesetzt werden. Bei Verwendung von niederschmelzendem Glas ist die Temperaturbelastung doch deutlich geringer.

Gemäß einer Weiterbildung ist vorgesehen, dass zusätzlich eine weitere Schicht aus weiterem Glasmaterial aufgebracht wird. Dieses Glasmaterial ist vorzugsweise dasselbe wie das in Schritt a) mit Leuchtstoff bedeckte Glasmaterial; es kann jedoch auch ein anderes Glasmaterial (beispielsweise ein Dünnglas oder Ultradünnglas mit abweichender Materialzusammensetzung verwendet werden. Das Laminat wird gemäß den Verfahrensschritten c) bis e) hergestellt, also vorzugsweise durch eine weitere Temperaturbehandlung.

Die Durchführung der Schritte c) bis e) gemäß der obigen Weiterbildung bietet sich insbesondere an, wenn zwei verschiedene bzw. verschiedenartige Leuchtstoffe durch Einsinken in das Glasmaterial eingesenkt werden sollen. In diesem Fall wird der erste Leuchtstoff in das in Schritt a) behandelte Glasmaterial eingebracht, wohingegen der zweite Leuchtstoff in die Schicht des weiteren Glasmaterials (z. B. in ein zweites Glassubstrat in Form eines Dünnglases oder Ultradünnglases) eingebracht wird. Dadurch sind beide Leuchtstoffarten auch nach dem Einsinken räumlich voneinander getrennt; es entsteht eine Art Laminat mehrerer Teilschichten aus mit unterschiedlichen Leuchtstoffarten und/oder Leuchtstoffkonzentrationen versehenem Glasmaterialien. In Richtung der Schichtdicke des Konversionselements sind die Positionen der maximalen Konzentration der ersten Leuchtstoffart und der zweiten Leuchtstoffart beispielsweise um eine Entfernung, die etwa der Dicke des nachträglich aufgelegten Dünnglases oder Ultradünnglases entspricht, voneinander beabstandet.

Alternativ kann der weitere Leuchtstoff auch in einem separaten Verfahrensschritt auf die entgegengesetzte Oberfläche des (zuvor schon auf der einen Seite mit Leuchtstoff behandelten) Glasmaterials aufgebracht werden. Ferner können auch verschiedene Leuchtstoffarten in einer Schichtung als Mischung vorliegen. In einer weiteren Ausgestaltung werden zwei separat hergestellte Konversionselemente mit den beiden leuchtstoffhaltigen Oberflächen miteinander verbunden.

Einige Ausführungsbeispiele und Vergleichsbeispiele werden nachstehend mit Bezug auf die Figuren beschrieben. Es zeigen:
Die Figuren 1A bis 1D verschiedene Vorschläge für Formen eines für das beschriebene Verfahren zu verwendenden Glases,
Die Figuren 2A bis 2I verschiedene Verfahrensschritte einer Ausführungsart des vorgeschlagenen Herstellungsverfahrens für ein Konversionselement und
die Figuren 3 bis 7 verschiedene Ausführungsbeispiele von Anordnungen mit je einem Konversionselement und mindestens einem optischen oder optoelektronischen Bauelement.

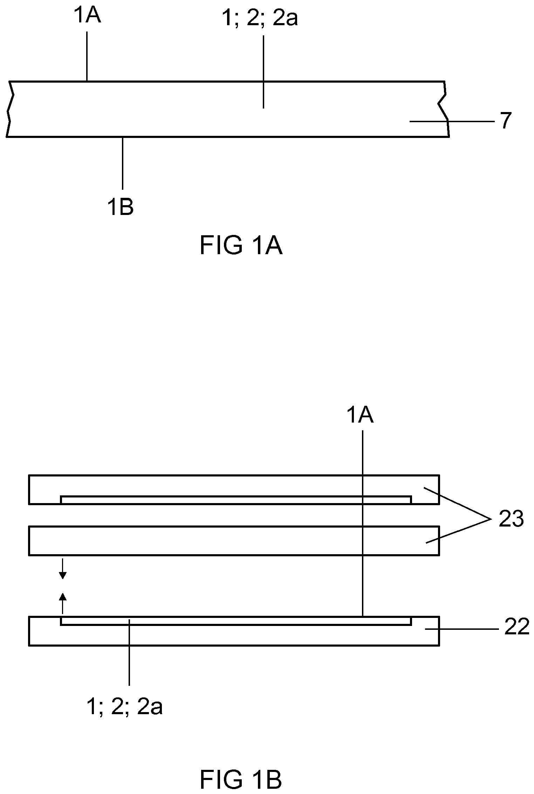

Für die Durchführung des hier vorgeschlagenen Verfahrens zur Herstellung eines Konversionselements wird zunächst leuchtstofffreies Glasmaterial verwendet; beispielsweise gemäß einer der Figuren 1A bis 1D. Gemäß Figur 1A wird das Glasmaterial 2a in Form eines festen, vorgeformten Glassubstrats 1 verwendet. Das Glassubstrat 1 kann insbesondere ein Dünnglas 7 bzw. Ultradünnglas sein, welches eine Schichtdicke unterhalb von 1,0 mm, beispielsweise zwischen 5 und 100 µm, insbesondere zwischen 5 und 50 µm besitzt.

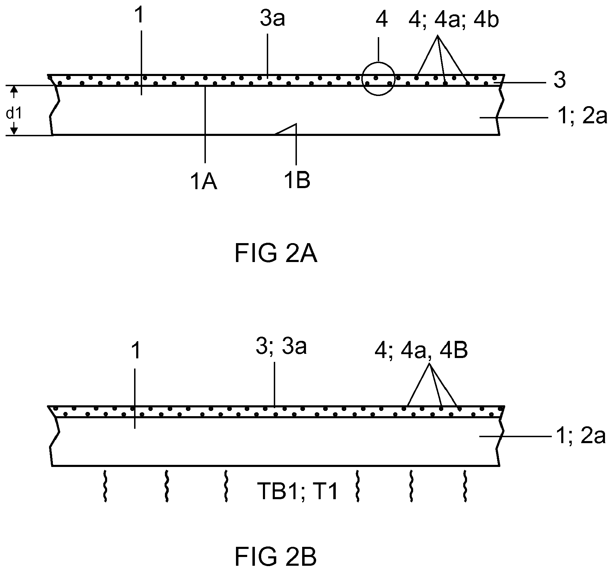

Gemäß Figur 1B kann als Unterlage für solch ein Glassubstrat eine Form 22 verwendet werden, die auch zum Aufheizen, d.h. zum Erweichen der Glasmasse 2 sowie zur Formgebung dient. Auf die obenliegende Oberfläche 1A des Glassubstrats 1 gemäß Figur 1A oder der Glasmasse 2 gemäß Figur 2B wird dann Leuchtstoff bzw. ein leuchtstoffhaltiges Material aufgebracht, und zwar vorzugsweise vor dem Aufheizen. Alternativ kann auch die Form mit Leuchtstoff beschichtet werden, der so gleichzeitig als Trennmittel wirkt. Da sich das Glas beim Erweichen aufgrund der Oberflächenspannung zusammenzieht, sollte dieses während der Temperaturbehandlung durch eine Pressform 23 in Form gehalten werden. Alternativ kann es auch nur während des Abkühlvorgans in Form gebracht werden.

In Figur 1B sind außer der als Unterlage dienenden Form 22 noch zwei verschiedene Pressformen 23 dargestellt. Eine der beiden Pressformen 23 wird zur Formgebung während des Abkühlvorgangs verwendet, d.h. gegen die Form 22 gedrückt, damit das erweichte und mit dem eingesunkenen Leuchtstoff versehene Glas während des Abkühlens seine äußere Form (entsprechend den Aussparungen in den Formteilen 22, 23) beibehält. Die Form 22 und die Pressform 23 können beide mit Leuchtstoff beschichtet sein, sodass dieser insbesondere in beide Oberflächen des Glases einsinkt. Im Vergleich dazu kann auch eine der beiden Oberflächen mit anderen, z.B. keramischen Partikeln beschichtet sein, die ebenfalls einsinken und später das Licht streuen. Der optische Brechungsindex dieser Partikel unterscheidet sich von dem des Glases vorzugsweise um 0,1 oder mehr. Das gemäß Figur 1B durch die Form 22 gestützte Glasmaterial 2a kann auch ein dickeres Glas sein. Hierfür wird vorzugsweise die obere Pressform 23 aus Figur 1B (mit Aussparung) verwendet. Dabei bestimmen dann die Aussparungen in der Form 22 und in der Pressform 23 gemeinsam die Gestalt des abkühlenden Glaskörpers. Sofern ein dünnes oder ultradünnes Glassubstrat verwendet wird, genügt die Aussparung in der Form 22; in diesem Fall wird vorzugsweise die untere Pressform 23 aus Figur 1B (ohne Aussparung) verwendet.

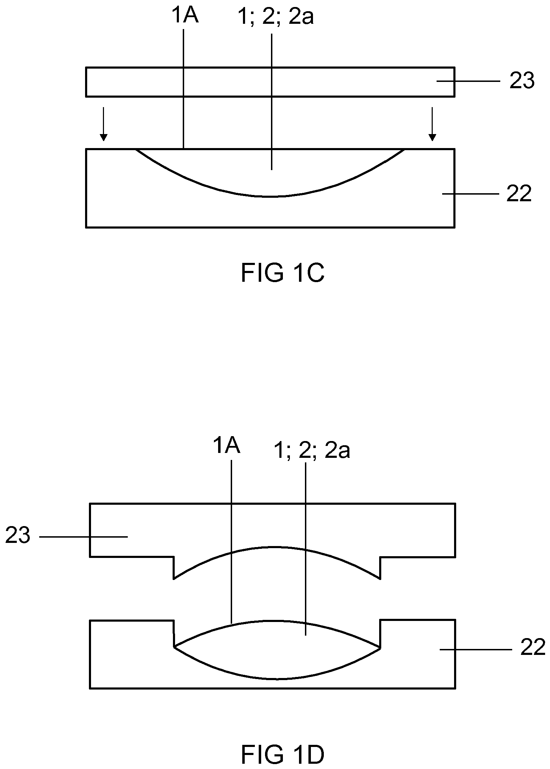

Alternativ zu einem fertig geformten Glassubstrat kann die Form 22 auch zur Formgebung verwendet werden, indem diese mit einer Glasschmelze gefüllt wird. In diesem Fall besitzt das Glas typischerweise eine Viskosität im Bereich von η = 10² bis 10⁴ dPa·s. Die mit Leuchtstoff zu bedeckende Glasmasse 2 braucht zudem keine planparallele Schicht zu sein, sondern kann gemäß Figur 1C auch als linsenförmiger (erkalteter oder erhitzter) Glaskörper in einer entsprechend ausgeformten Form 22 vorliegen.

Zum Einbringen von Leuchtstoff in eine gewölbte Oberseite 1A einer linsenförmigen oder anderweitig gekrümmten Bauform des Glaskörpers kann, wie in Figur 1D dargestellt, eine mehrteilige Anordnung aus einer unterseitigen Form 22 und einer oberseitigen Pressform 23 eingesetzt werden, wobei die Pressform 23 während der Durchführung die Temperaturbehandlung zumindest zeitweise, vorzugsweise zumindest während des Abkühlvorgangs, gegen die Form 22 gepresst wird, um während des Erkaltens des Glasmaterials 2a die gewünschte Formgebung zu gewährleisten. Solange die Pressform 23 noch nicht in die Form 22 eingreift, ist die gekrümmte Oberfläche 1A für das Aufbringen des Leuchtstoffs zugänglich.

Das gemäß einer der Figuren 1A bis 1D oder auf sonstige Weise bereitgestellte Glasmaterial 2a, das das Ausgangsmaterial für das Verfahren bildet, ist somit eine homogene, kompakte, zusammenhängende und leuchtstofffreie (und im Übrigen transparente) sowie möglichst blasenarme Glasmasse. Im Vergleich zu dem in DE 10 2008 021 438 A1 beschriebenen Sinterverfahren liegt hier das Glas bereits blasenarm vor und wird nur noch so weit erweicht, dass der Leuchtstoff in dessen Oberfläche einsinkt. Dies erfolgt in der Regel bei tieferen Temperaturen als beim Sinterverfahren, da die Leuchtstoffpartikel viskositätserhöhend wirken und so die zwischen den Pulverpartikeln eingeschlossene Luft erst bei höheren Temperaturen entweichen kann oder bei gezieltem Einsatz von Unterdruck. Der Blasenanteil (Porosität) ist u.a. eine wichtige Konstante für die Abstrahlcharakteristik des Konversionselements. Zur Erzielung der gleichen Lichtfarbe nimmt die Dicke des Konversionselements mit steigender Porosität zu. Dies führt zu einer verstärkten Abstrahlung zur Seite (wie z.B. als "gelber Ring") und so zu einer inhomogeneren Lichtverteilung über den Winkel. Der Vorteil des hier beschriebenen Verfahrens ist, dass der Leuchtstoff nur in die Oberfläche einsinkt und so an ihr konzentrierter vorliegt, also in vertikaler Richtung (in Richtung der Schichtdicke) inhomogen verteilt ist. Diese Oberfläche wird vorzugsweise chipnah positioniert, sodass der Leuchtstoff möglichst dicht am Chip sitzt. Der Bereich, an dem der eingesunkene Leuchtstoff vorliegt, ist somit kleiner als der im homogenen verteilten Sinterteil. Als Leuchtstoff sind Granate (wie z.B. YAG:Ce, LuAG usw.), Nitride, SiONe und/oder Orthosilikate einsetzbar, mit denen verschiedene Farborte eingestellt werden können. Das hier beschriebene Konversionselement kann auch in Kombination mit einer Konversionskeramik als Laminat, auch mit anderer Lichtfarbe, eingesetzt werden. Auch in diesem Fall liegt die leuchtstoffreiche Seite des glasigen Konversionselements vorzugsweise chipnah, d.h. keramiknah vor (wobei die Keramik zwischen dem Chip und dem glasigen Konversionselement angeordnet ist). In dieser Ausgestaltung können das glasige Konversionselement und die Konversionskeramik auch mit Hilfe einer weiteren Temperaturbehandlung (analog zu TB2) direkt miteinander verklebt sein. Die Konversionselemente können sowohl direkt auf dem Chip als auch mit Abstand zum Chip (remote phosphor) angebracht sein. Die Konversionselemente können wie üblich mit Silikon, mit einem niederschmelzenden Glas oder mittels Sol-Gel auf dem Chip als auch untereinander befestigt sein. Das Glas für die Durchführung der nachfolgend beschriebenen Verfahrensschritte kann wahlweise in bereits erhitztem Zustand oder als zunächst kalter, vorgeformter Glaskörper vorliegen.

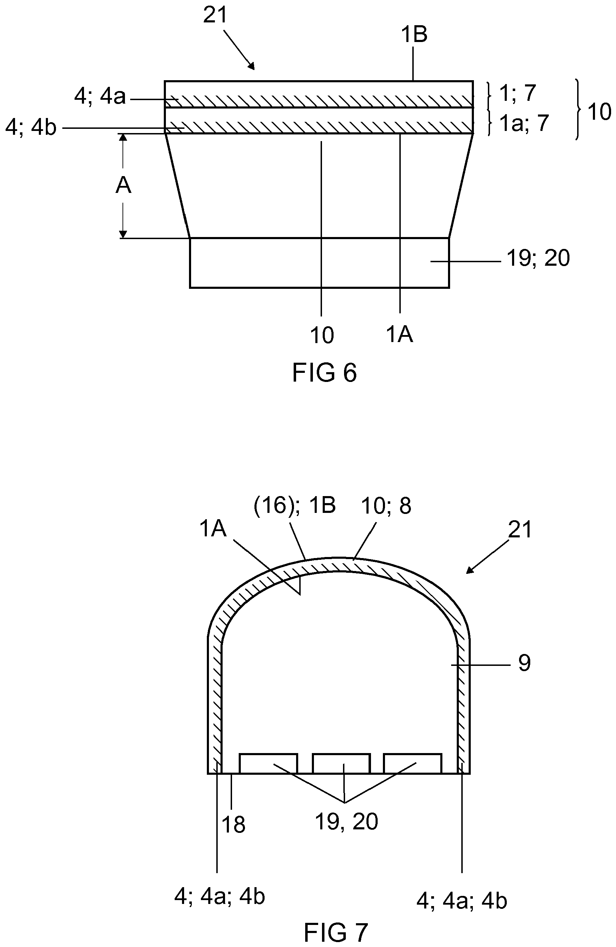

Gemäß Figur 2A wird eine Schicht 3 aus einem Leuchtstoffhaltigen Material 3a auf die Oberfläche 1A der Glasmasse aufgebracht. Die Glasmasse kann beispielsweise ein ebenes, planparalleles Glassubstrat 1 (wie in Figur 1A und 1B) sein oder ein in sonstiger Weise, etwa linsenartig (wie in Figur 1C oder 1D) oder kolbenförmig (wie in Figur 7) geformter Glaskörper sein. Ebenso kann die Glasmasse, die gemäß den Figuren 2A bis 2I als Substrat 1 verwendet wird, eine vorgeheizte, insbesondere über ihre Erweichungstemperatur hinaus erhitzte, aber noch nicht fließfähige Glasmasse 2a sein (Figur 1C oder 1D). Im Folgenden wird hinsichtlich der verschiedenen denkbaren Erscheinungsformen des Glasmaterials 2a nicht mehr unterschieden und der Kürze halber nur noch auf das Glassubstrat 1 Bezug genommen. Wie in allen übrigen Figuren auch sind die Größenverhältnisse, insbesondere die schematisch dargestellten Schichtdicken nicht maßstabsgetreu.

Gemäß Figur 2B wird eine Temperaturbehandlung TB1 bei einer Temperatur T1 oberhalb der Erweichungstemperatur des Glasmaterials 2a durchgeführt, wobei die maximale Temperatur T1 nur während eines Teils der Dauer der Temperaturbehandlung TB1 erreicht zu werden braucht. Die Temperaturbehandlung TB1 kann nach dem Aufbringen einer Schicht 3 aus Leuchtstoff 4 bzw. leuchtstoffhaltigem Material 3a durchgeführt werden, aber auch schon während oder vor dem Aufbringen des leuchtstoffhaltigem Materials eingeleitet werden. In dem Fall, dass die Temperaturbehandlung TB1 vor oder während des Aufbringens eingeleitet wird, ist vorzugsweise nur Leuchtstoffpulver ohne weitere Zusätze auf das Glasmaterial 2a aufzubringen.

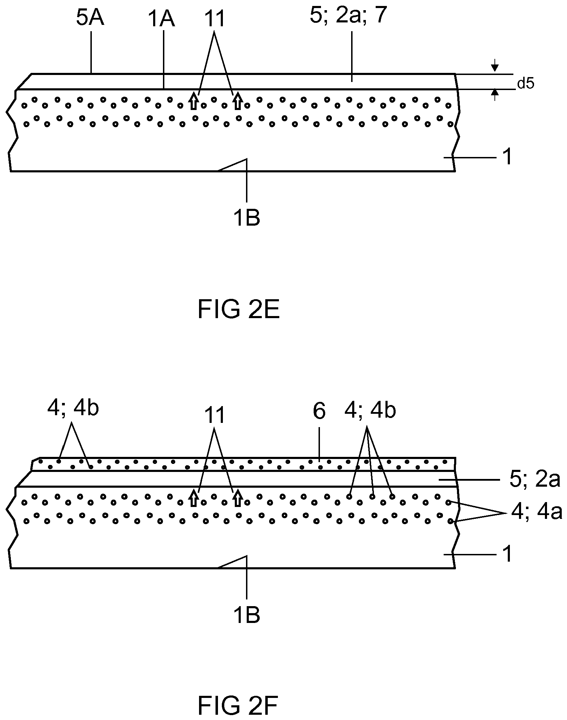

Die gemäß den Figuren 2A bzw. 2B aufgebrachte Schicht 3 enthält einen Leuchtstoff 4, der in Form fester Partikel in einer Suspension bzw. Lösung enthalten ist. Der Leuchtstoff 4 kann ein oder mehrere verschiedene Arten von Leuchtstoff 4a, 4b umfassen, um verschiedene Farborte zu erzeugen. Sofern bei späteren Verfahrensschritten (Figur 2F) erneut Leuchtstoff aufgebracht wird, wird gemäß den Figuren 2A und 2B vorzugsweise nur eine einzige Art von Leuchtstoff 4, nämlich 4a aufgebracht.

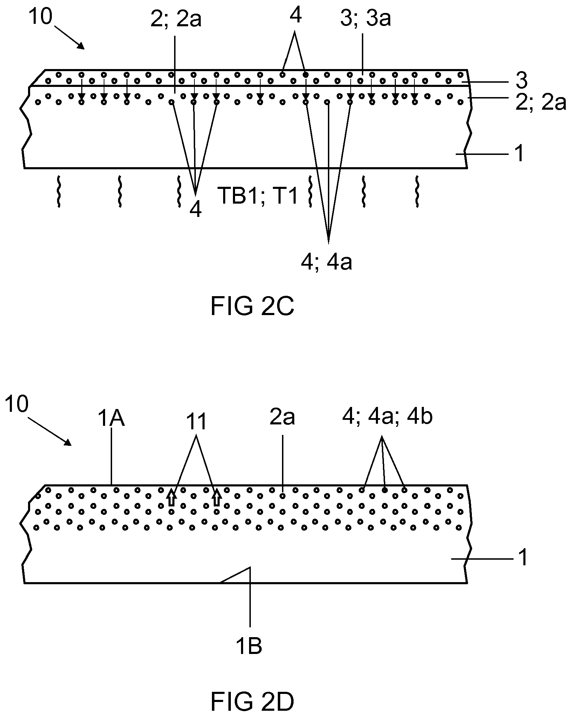

Figur 2C zeigt schematisch das Einsinken des Leuchtstoffs 4 während der Temperaturbehandlung TB1. Aus der Schicht 3 aus dem den Leuchtstoff 4, 4a enthaltenden Material 3a sinken die Leuchtstoffpartikel nach und nach in die Oberfläche des Glassubstrats 1 bzw. in die aufgeheizte Glasmasse 2 ein. Dieses durch die Erdanziehung bewirkte Einsedimentieren kann durch mechanisches Pressen, beispielsweise mit Hilfe einer Pressform 23 aus Figur 1D unterstützt und beschleunigt werden. Durch das Einsinken des Leuchtstoffs (in Figur 2C durch die nach unten weisenden Pfeile dargestellt) wird das Glassubstrat 1 bzw. die Masse des Glasmaterials 2a mit dem Leuchtstoff 4 versetzt.

Figur 2D zeigt schematisch die Verteilung des Leuchtstoffs 4 innerhalb des Glassubstrats 1; vorzugsweise ist der Leuchtstoff mengenmäßig überwiegend an bzw. nahe der oberseitigen Oberfläche 1A im Glasmaterial 2a konzentriert, d.h. inhomogen verteilt. Dabei weist der Gradient 11 der Leuchtstoffkonzentration innerhalb der Schichtdicke des Glassubstrats 1 in Richtung der ersten, oberseitigen Oberfläche 1A; die Konzentration des Leuchtstoffs 4a nimmt an oder dicht unterhalb der Oberfläche 1A ein lokales Maximum an.

Gemäß einer Weiterbildung ab Figur 2E kann später noch weiteres Glasmaterial aufgebracht und mit weiterem Leuchtstoff versehen werden. Das gemäß Figur 2D behandelte Glassubstrat 1 stellt jedoch (nach dem Abkühlen) an sich bereits ein fertiges Konversionselement 10 dar, das mit einem oder mehreren optoelektronischen Bauelementen bzw. Halbleiterchips verbaut werden kann.

Das Konversionselement 10 aus Figur 2D kann auch erst noch weiteren Bearbeitungsschritten unterzogen werden. Beispielsweise kann nun von der entgegengesetzten Oberfläche 1B her weiterer Leuchtstoff 4 (beispielsweise anderer Leuchtstoff 4b als der in Figur 2A aufgebrachte Leuchtstoff) aufgebracht und durch eine zweite Temperaturbehandlung von der Oberfläche 1B aus durch Einsinken in das Glassubstrat 1 eingebracht werden. Für das Aufbringen und Einsinken des weiteren Leuchtstoffs 4b wird das Konversionselement 10 aus Figur 2D umgedreht, damit die Oberfläche 1B nach oben weist.

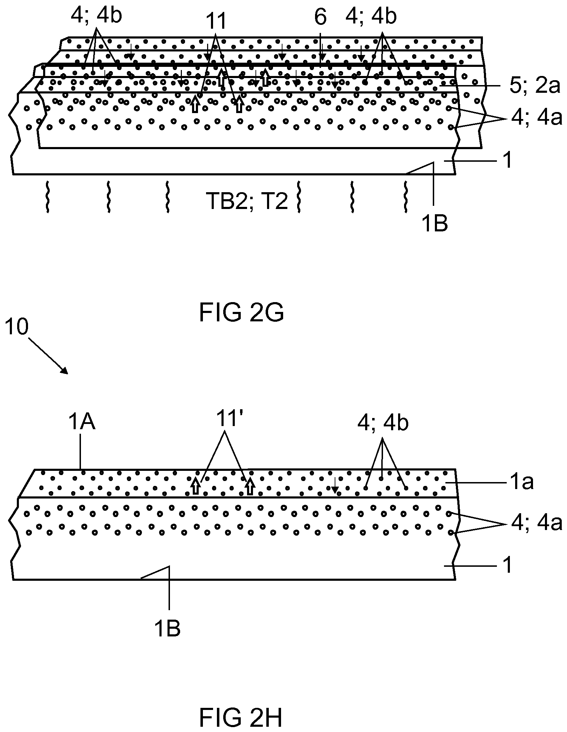

Gemäß einer alternativen Weiterbildung, die in den Figuren 2E bis 2H dargestellt ist, kann (gemäß Figur 2E) eine Schicht 5 der Schichtdicke d5 aus weiterem Glasmaterial 2a auf dieselbe Oberfläche 1A aufgebracht werden und (gemäß Figur 2F) auf ihrer dann freiliegenden Oberseite 5A ebenfalls mit einer weiteren Schicht 6 aus leuchtstoffhaltigem Material bedeckt werden. Insbesondere wird hierbei ein anderer Leuchtstoff 4; 4b aufgebracht als derjenige, der zuvor gemäß Figur 2A aufgetragen wurde. Die auf diese Weise mit weiterem Leuchtstoff 4; 4b bedeckte Schicht 5 kann beispielsweise ein Dünnglas 7 bzw. Ultradünnglas sein, dessen Schichtdicke vorzugsweise kleiner als 1,0 mm ist und insbesondere zwischen 5 µm und 100 µm, vorzugsweise zwischen 5 µm und 50 µm betragen kann. Anschließend wird gemäß Figur 2G eine zweite Temperaturbehandlung TB2 bei einer Temperatur T2 durchgeführt, um den weiteren Leuchtstoff 4b durch Einsinken in die Schicht 5 aus dem weiteren Glasmaterial 2a einzubringen, wie in Figur 2G durch die nach unten weisenden Pfeile angedeutet ist.

Auf diese Weise entsteht das in Figur 2H schematisch dargestellte Konversionselement 10, das über dem zuerst behandelten Glassubstrat 1 eine weitere Teilschicht 1a aus leuchtstoffhaltigem Glas (aus entweder demselben oder einem anderen Grundmaterial, sowie dem Leuchtstoff 4; 4b) aufweist. In der Praxis werden das ursprüngliche Glassubstrat 1 und die Teilschicht 1a zu einer einheitlichen Glasschicht des Konversionselements 10 verschmolzen sein. Dennoch ist in Figur 2H und den weiteren nachfolgenden Figuren die ehemalige Grenzfläche zwischen dem Substrat 1 bzw. der unteren Teilschicht aus leuchtstoffhaltigem Glas und der oberen Teilschicht 1a aus weiterem leuchtstoffhaltigem Glas als Trennlinie dargestellt, um den Verlauf der Leuchtstoffkonzentration im Inneren des Konversionselements 10 zu kennzeichnen. Das Konversionselement 10 aus Figur 2H bildet eine Art Laminat, in dem der erste Leuchtstoff 4a in Richtung der Schichtdicke des Konversionselements an einer Position zwischen zwei Teilschichten 1, 1a konzentriert ist. Vorzugsweise ist die obere Teilschicht 1a dünner als die untere Teilschicht bzw. das frühere Glassubstrat 1, sodass auch die Konzentration des ersten Leuchtstoffs 4a näher an der Oberfläche 1A liegt als an der entgegengesetzten Oberfläche 1B. So wie in Figur 2D die Konzentration der zuerst eingebrachten Leuchtstoffpartikel 4a mit abnehmendem Abstand von der Oberfläche 1A, d.h. der späteren Grenzfläche zur oberen Teilschicht 1a ansteigt (wie durch den Gradienten 11 angedeutet), steigt auch gemäß Figur 2H die Konzentration des eingesunkenen weiteren Leuchtstoffs 4b mit abnehmendem Abstand von der freiliegenden Oberseite 1A an (wie durch den Gradienten 11' angedeutet ist) an. Wenn daher die Teilschichten 1 und 1a des Konversionselements 10 miteinander verschmolzen sind, bildet die ehemalige Grenzfläche zwischen ihnen ungefähr die Position der maximalen Konzentration des ersten Leuchtstoffs 4a, wohingegen die maximale Konzentration des zweiten Leuchtstoffs 4b an der Oberfläche 1A des Konversionselements 10 liegt, d.h. an der früheren Oberfläche 5A der zuvor aufgebrachten Schicht 5 (Figur 2E). Bei dem gemäß Figur 2H erhaltenen Konversionselement 10 sind der erste und der zweite Leuchtstoff 4a, 4b somit räumlich voneinander getrennt.

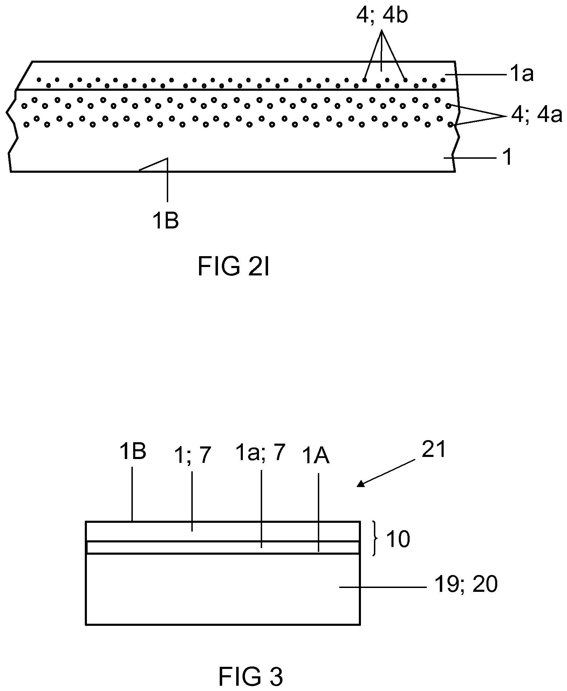

Alternativ können jedoch auch zwei separat hergestellte Konversionselemente, in die jeweils Leuchtstoff 4 von einer Oberfläche her durch Einsinken eingebracht wurde, miteinander verbunden werden. Die beiden Konversionselemente können insbesondere mit ihren beiden leuchtstoffhaltigen Oberflächen aneinander befestigt werden. Dadurch entsteht das in Figur 2I dargestellte, zusammengesetzte Konversionselement, bei dem sowohl die Konzentration des (ersten) Leuchtstoffs 4; 4a innerhalb der Teilschicht 1 als auch die Konzentration des (zweiten) Leuchtstoffs 4; 4b innerhalb der Teilschicht 1a jeweils zur Grenzfläche zwischen beiden Teilschichten 1, 1a hin ansteigt.

Die Figuren 3 bis 7 zeigen exemplarische Ausführungsbeispiele eines Konversionselements 10, das mit mindestens einem optischen und/oder optoelektronischen Bauelement 20, insbesondere einem Halbleiterchip 19 verbaut ist. Die in Figur 2H obengelegene Oberfläche 1A, bei der die Konzentration des Leuchtstoffs 4b am größten ist, ist gemäß Figur 3 mit dem Bauelement 20 verbunden. Von der entgegengesetzten Oberfläche 1B her nimmt die Konzentration des ersten Leuchtstoffs 4a mit zunehmender Nähe zum Bauelement 20 zu. Das Konversionselement 10 kann auch lediglich aus dem Glassubstrat 1 (etwa einem Dünnglas 7) alleine bestehen; die Teilschicht 1a aus leuchtstoffhaltigen Glas entfällt dann, sodass das Konversionselement 10 demjenigen aus Figur 2D entspricht. Sofern die Teilschicht 1a jedoch vorgesehen ist, ist sie vorzugsweise ein Dünnglas 7 oder Ultradünnglas. Das zuerst bearbeitete Glassubstrat 1 (bzw. die daraus hervorgegangene Teilschicht des Glasmaterials) braucht kein Dünnglas zu sein.

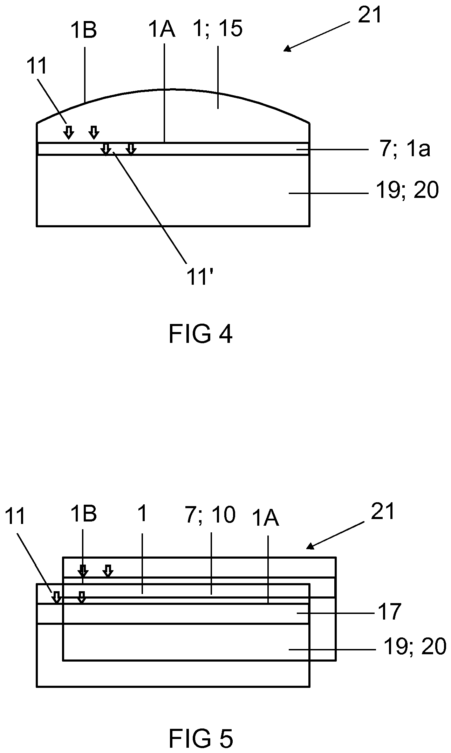

Insbesondere kann das Substrat 1 wie in Figur 4 als optische Linse 15 ausgebildet sein und eine gekrümmte (rückseitige) Oberfläche 1B besitzen. In Figur 4 sind die Gradienten 11 und 11' der Konzentrationen des ersten und des zweiten Leuchtstoffs 4a, 4b dargestellt, die jeweils zum Bauelement 20 hinweisen. Ebenso wie in Figur 3 kann das Dünnglas 7 bzw. die Teilschicht 1a entfallen.

Figur 5 zeigt eine Ausführungsform einer Anordnung 21, die zwischen dem Glassubstrat 1 und dem Bauelement 20 noch eine keramische Konversionsschicht 17 aufweist. Die keramische Konversionsschicht 17 kann anderen Leuchtstoff als das Glassubstrat enthalten. Eine keramische Konversionsschicht besitzt eine höhere Wärmeleitung als ein Glassubstrat, hat jedoch den Nachteil, dass nur Leuchtstoffe für bestimmte Farben bzw. Spektralbereiche eingebracht werden können. Die keramische Konversionsschicht kann eine Schichtdicke zwischen 50 und 300 µm, vorzugsweise zwischen 100 und 200 µm oder auch unterhalb von 100 µm (beispielsweise größer als 50 µm) besitzen. Das Glassubstrat 1 kann ein Dünnglas oder Ultradünnglas (mit der in dieser Anmeldung bereits genannten Bandbreite für seine Schichtdicke) sein, aber auch ein dickeres, planparalleles Glas (mit einer Schichtdicke bis zu 2 mm) oder alternativ ein (wie in Figur 4 oder auf andere Weise) als optisches Element ausgeformtes Glas.

Figur 6 zeigt eine Ausführungsform, bei der das Konversionselement 10 in einem Abstand A beabstandet vom optoelektronischen Bauelement 20 bzw. Halbleiterchip 19 angeordnet ist. Das Konversionselement 10 ist beispielsweise wie dasjenige aus Figur 3 aufgebaut, d.h. mit zwei verschiedenen Teilschichten 1, 1a mit jeweils zum Halbleiterchip 19 hin ansteigender Konzentration des jeweiligen Leuchtstoffs 4a bzw. 4b. Die ansteigende Leuchtstoffkonzentration ist in Figur 6 durch schraffierte untere Bereiche der jeweiligen Schicht 1, 1a dargestellt (statt durch Gradientenpfeile 11, 11' wie in Figur 4). Beide Schichten 1, 1a können jeweils ein Dünnglas 7 oder Ultradünnglas (mit der in dieser Anmeldung bereits genannten Bandbreite für seine Schichtdicke) darstellen. Vorzugsweise ist zumindest die untere Teilschicht 1a ein Dünnglas oder Ultradünnglas. Das Konversionselement 10 kann mit einem Reflektor oder einer sonstigen Fassung im Abstand A vom Halbleiterchip 19 gehalten werden. Das Konversionselement 10 kann auch so beschaffen sein, dass sämtliche Leuchtstoffe 4a, 4b ihre maximale Leuchtstoffkonzentration an der unteren, dem Halbleiterchip 19 zugewandten Oberfläche 1A besitzen; dementsprechend würde die Teilschicht 1a (und der dadurch bedingte vertikale Versatz zwischen den Maximalkonzentrationen der jeweiligen Leuchtstoffe 4a, 4b) entfallen.

Figur 7 zeigt eine Ausführungsform, bei der das Konversionselement 10 als kolbenförmiger Glaskörper 8 ausgebildet ist. Der Glaskörper 8 ist auf derjenigen Oberfläche 1A, bei der die Konzentration des Leuchtstoffs 4 (durch Schraffur gekennzeichnet) am größten ist, konkav geformt und schließt somit einen Hohlraum 9 ein. Die entgegengesetzte, leuchtstoffarme Oberfläche 1B weist konvex nach außen und ist gemäß Anspruch 9 mit einer Streuschicht 16 bedeckt. Diese Streuschicht ist ebenso auf den Konversionselementen 10 aller anderen Ausführungsformen, insbesondere denjenigen der Figuren 2D, 2H und 3 bis 6 vorhanden. In Figur 7 können auf einer Trägerplatte 18 wahlweise ein einziger oder auch mehrere Halbleiterchips 19 bzw. Bauelemente 20, die jeweils elektromagnetische Strahlung aussenden, angeordnet sein. Gerade im Falle einer Mehrzahl von Bauelementen 20 wird mit Hilfe der Aufrauhung oder Streuschicht 16 eine Verbesserung der Abstrahlcharakteristik erreicht. Das Konversionselement 10 ist beabstandet von den optoelektronischen Bauelementen 20 angeordnet, wobei die Oberfläche 1A maximaler Leuchtstoffkonzentration, von der aus der Leuchtstoff 4 in das Glasmaterial eingebracht wurde, den Bauelementen 20 zugewandt ist. In Figur 6 und 7 kann jeweils alternativ auch ein erstes Konversionselement unmittelbar auf dem Chip oder der Mehrzahl von Chips montiert sein und ein zweites Konversionselement, insbesondere ein solches mit einem anderen Leuchtstoff, beabstandet (wie dargestellt) angeordnet sein.

Für das in der Anmeldung vorgeschlagene Konversionselement können Hartgläser, Weichgläser oder sogar niederschmelzende (insbesondere bleifreie) Gläser eingesetzt werden. Für den Fall, dass das Konversionselement auf dem Chip befestigt wird oder in Kombination mit einem keramischen Konversionselement verwendet wird, werden vorzugsweise Gläser mit einem Ausdehnungskoeffizienten α (20 - 300 °C) zwischen 6 x 10⁻⁶/K und 20 x 10⁻⁶/K, idealerweise zwischen 8 x 10⁻⁶/K und 12 x 10⁻⁶/K eingesetzt. Wird ein Glas eingesetzt, dessen optischer Brechungsindex ähnlich dem des eingesunkenen Leuchtstoffs ist (z.B. mit einem Brechungsindex nD ungefähr bei 1,8 bei Granaten), so kann die Effizienz des optischen Bauelements nochmals gesteigert werden. Das Konversionselement kann dann mit einer leuchtstofffreien Silikonschicht, einer Schicht aus niederschmelzendem Glas oder mittels eines Sol-Gel-Verfahrens an dem Bauelement befestigt werden.

Sofern als Glasmaterial anstelle eines Weichglases oder Hartglases (mit Erweichungstemperaturen zwischen 650 und 950 °C) ein bleifreies, niederschmelzendes Glas (mit einer Erweichungstemperatur etwa zwischen 400 bis 600 °C) verwendet wird, kann dieses Glas als Hauptbestandteil ein zinkhaltiges Borosilikat-Glas, ein Zink-Wismut-Borosilikat-Glas, ein Aluminiumphosphat-Glas, ein Aluminium-Zink-Phosphat-Glas oder ein Alkaliphosphat-Glas enthalten. Als Leuchtstoff zum Einsinken in das Hartglas, Weichglas oder niederschmelzende Glas kann beispielsweise ein Granat (wie z.B. YAG:Ce, LuAG usw.), ein Nitrid, ein SiON und/oder ein Orthosilikat eingesetzt werden. Zudem können mehrere verschiedene Arten von Leuchtstoffen in Kombination miteinander verwendet werden, um zwei oder mehr verschiedene Sekundärspektren bzw. einen bestimmten Farbort zu erzeugen. Ein erster Leuchtstoff kann in eine erste Teilschicht des Konversionselements 10 eingebracht und ein zweiter, anderer Leuchtstoff kann in eine zweite, andere Teilschicht des Konversionselements eingebracht sein.

Mit Hilfe des erfindungsgemäß nachträglichen vorgenommenen Einsinkens von Leuchtstoff lässt sich insbesondere eine in Richtung der Schichtdicke des Glases bzw. Glasmaterials inhomogene Verteilung des jeweiligen Leuchtstoffs erzeugen. In Richtung parallel zu den Oberflächen 1A, 1B des Konversionselements kann die Verteilung des Leuchtstoffs homogen sein. Alternativ kann auch in lateraler Richtung eine inhomogene Leuchtstoffverteilung vorliegen. Dazu ist der Leuchtstoff in den Figuren 2A und 2F inhomogen auf die Oberfläche des Glasmaterials aufzubringen. Durch geeignete Wahl der lateralen Leuchtstoffverteilung lässt sich die Abstrahlcharakteristik gezielt beeinflussen. Als zusätzliche Maßnahme oder alternativ dazu kann das Konversionselement der Figuren 2D, 2H oder 3 bis 7 auf einer Oberfläche 1A aufgeraut oder mit einer Streuschicht versehen sein. So kann bei einem vom Bauelement beabstandeten Konversionselement in Kugelform oder Halbkugelform die Abstrahlcharakteristik verbessert werden. Dies bewirkt etwa bei Retrofit-Lampen mit mehreren Bauelementen (insbesondere unterschiedlicher Lichtfarbe) unterhalb des Konversionselements eine gleichmäßigere Farbverteilung.

## Patentansprüche

1. Verfahren zur Herstellung eines Konversionselements (10) für ein optisches und/oder optoelektronisches Bauelement (20), wobei das Verfahren mindestens die folgenden Schritte umfasst:
a) Aufbringen von Leuchtstoff (4; 4a) oder eines Materials (3a), das Leuchtstoff (4; 4a) enthält, auf eine Oberfläche (1A) eines transparenten, leuchtstofffreien und homogenen Glasmaterials (2a) und Durchführen einer Temperaturbehandlung (TB1) bei erhöhter Temperatur (T1) oberhalb der Erweichungstemperatur (Tw) des Glasmaterials (2a),
wodurch das Glasmaterial (2a) soweit erweicht wird, dass der Leuchtstoff (4; 4a) in das Glasmaterial (2a) einsinkt, und
b) Abkühlen des Glasmaterials (2a) samt des eingesunkenen Leuchtstoffs (4; 4a), und wobei zuerst die Temperaturbehandlung (TB1) des Glasmaterials (2a) eingeleitet wird, bevor der Leuchtstoff (4; 4a) auf die Oberfläche (1A) des erweichten oder zumindest erhitzten Glasmaterials (2a) aufgebracht wird.

2. Verfahren nach Anspruch 1,
**dadurch gekennzeichnet, dass**
der Leuchtstoff (4; 4a) oder das den Leuchtstoff (4; 4a) enthaltende Material (3a) durch Aufsprühen, Aufstreichen, Aufpinseln, elektrostatisches Abscheiden, oder auf sonstige Weise unmittelbar auf die Oberfläche (1A) des Glasmaterials (2a) oder als Trennmittel auf eine zur Formgebung des Glasmaterials bestimmte Form (22) oder Pressform (23) aufgebracht wird.

3. Verfahren nach Anspruch 1 oder 2,
**dadurch gekennzeichnet, dass**
das Glasmaterial (2a) als kompakte, zusammenhängende und blasenarme Glasschicht mit dem Leuchtstoff (4; 4a) oder dem den Leuchtstoff (4; 4a) enthaltenden Material (3a) bedeckt und der Temperaturbehandlung (TB1) unterzogen wird.

4. Verfahren nach einem Anspruch 3,
**dadurch gekennzeichnet, dass**
die kompakte, zusammenhängende und blasenarme Glasschicht in noch nicht erhitztem Zustand bereitgestellt wird und durch die Temperaturbehandlung (TB1) erweicht wird.

5. Verfahren nach einem der Ansprüche 1 bis 4,
**gekennzeichnet durch** die weiteren Schritte vor, während und/oder nach dem Abkühlen des Glasmaterials (2a):
c) Aufbringen einer Schicht (5) aus weiterem Glasmaterial auf das in Schritt a) behandelte Glasmaterial (2a),
d) Aufbringen von weiterem Leuchtstoff (4; 4b) oder einer weiteren Leuchtstoff (4; 4b) enthaltenden Schicht auf eine Oberfläche (5A) der weiteren Schicht (5), wobei die Oberfläche (5A) von dem in Schritt a) behandelten Glasmaterial (2a) abgewandt ist, und
e) Einbringen des weiteren Leuchtstoffs (4; 4b) in die abgewandte Oberfläche (5A) des weiteren Glasmaterials (2a) durch Einsinken bei erhöhter Temperatur (T2).

6. Verfahren nach Anspruch 5,
**dadurch gekennzeichnet, dass**
das weitere Glasmaterial auf die bereits mit Leuchtstoff (4; 4a) bedeckte Seite des in Schritt a) behandelten Glasmaterials (2a) aufgebracht und in den Schritten d) und e) mit einem anderen Leuchtstoff (4; 4b) als das in Schritt a) behandelte Glasmaterial (2a) versehen wird.

7. Verfahren nach einem der Ansprüche 1 bis 4,
**gekennzeichnet durch** die weiteren Schritte vor, während und/oder nach dem Abkühlen des Glasmaterials (2a):
c) Aufbringen von weiterem Leuchtstoff (4; 4b) oder einer weiteren Leuchtstoff (4; 4b) enthaltenden Schicht (6) auf ein weitere, entgegengesetzte Oberfläche (1B) des in Schritt a) behandelten Glasmaterials (2b) und
d) Einbringen des weiteren Leuchtstoffs (4; 4b) in die zweite, entgegengesetzte Oberfläche durch Einsinken bei erhöhter Temperatur (T2).

8. Verfahren nach einem der Ansprüche 1 bis 6,
**dadurch gekennzeichnet, dass**
das in Schritt a) oder c) verwendete Glasmaterial (2a) ein planparalleles Dünnglas oder Ultradünnglas mit einer Glasdicke von zwischen 5 µm und 1000 µm, vorzugsweise zwischen 5 µm und 500 µm, oder ein kolbenförmiger Glaskörper (8) mit einem Hohlraum (9) auf einer Seite oder eine Linse ist.

9. Konversionselement (10) für ein optisches und/oder optoelektronisches Bauelement (20), wobei das Konversionselement (10) zumindest Folgendes aufweist:
- Ein transparentes, schichtförmiges oder in sonstiger Weise geformtes Glassubstrat (1),
- wobei das Glassubstrat (1) zumindest eine plane oder gewölbte erste Oberfläche (1A) und eine zur ersten Oberfläche (1A) entgegengesetzte, plane oder gewölbte zweite Oberfläche (1B) aufweist, zwischen denen das Glassubstrat (1) eine konstante oder variierende Schichtdicke (d10) besitzt,
- wobei das Konversionselement (10) aus einem Glasmaterial (2a) gebildet ist, welches Leuchtstoff (4; 4a, 4b) enthält,
- wobei der Leuchtstoff (4; 4a, 4b) in Richtung der Schichtdicke (d10) des Konversionselements (10) inhomogen verteilt ist und
- wobei die Konzentration des Leuchtstoffs (4; 4a, 4b) an einer ersten Oberfläche (1A) der beiden Oberflächen (1A, 1B) ein lokales Maximum besitzt und in Richtung zur zweiten, entgegengesetzten Oberfläche (1B) hin abnimmt, und wobei
das Konversionselement (10) an der zweiten, entgegengesetzten Oberfläche (1B) des Glasssubstrats (1) mit einer Streuschicht (16) bedeckt ist.

10. Konversionselement nach Anspruch 9,
**dadurch gekennzeichnet, dass**
das Glasmaterial (2a) des Konversionselements (10) zwei verschiedene Leuchtstoffe (4; 4a, 4b) enthält, von denen ein erster Leuchtstoff (4a) in Richtung der Schichtdicke des Konversionselements (10) in einer ersten Position zwischen beiden Oberflächen (1A, 1B) konzentriert ist, wohingegen ein zweiter Leuchtstoff (4b) überwiegend an einer ersten Oberfläche (1A) der beiden Oberflächen (1A, 1B) des Konversionselements (10) oder in einer zweiten Position, die in Richtung der Schichtdicke zwischen der ersten Oberfläche (1A) und der ersten Position liegt, konzentriert ist.

11. Konversionselement nach Anspruch 10,
**dadurch gekennzeichnet, dass**
die erste Oberfläche (1A) des Glasssubstrats (1) plan oder konkav geformt ist und dass der Abstand zwischen der ersten Oberfläche (1B) und der Position der maximalen Konzentration des zweiten Leuchtstoffs (4b), gemessen in Richtung der Schichtdicke (b10) des Konversionselements (10), kleiner als 1,0 mm, vorzugsweise kleiner als 200 µm ist.

## Claims

1. Method for producing a conversion element (10) for an optical and/or optoelectronic component (20), the method comprising at least the following steps:
a) applying phosphor (4; 4a) or a material (3a) containing phosphor (4; 4a) to a surface (1A) of a transparent, phosphor-free and homogeneous glass material (2a) and carrying out a temperature treatment (TB1) at an elevated temperature (T1) above the softening temperature (Tw) of the glass material (2a),
whereby the glass material (2a) is softened so that the phosphor (4; 4a) sinks into the glass material (2a), and
b) cooling of the glass material (2a) together with the sunken phosphor (4; 4a), and wherein first the temperature treatment (TB1) of the glass material (2a) is initiated before the phosphor (4; 4a) is applied to the surface (1A) of the softened or at least heated glass material (2a).

2. Method according to claim 1,
**characterised in that**
the phosphor (4; 4a) or the material (3a) containing the phosphor (4; 4a) is applied directly to the surface (1A) of the glass material (2a) by spraying, brushing, paint brushing, electrostatic deposition or in any other manner or as a release agent to a mould (22) or press mould (23) intended for shaping the glass material.

3. Method according to claim 1 or 2,
**characterised in that**
the glass material (2a) is covered as a compact, coherent and low-bubble glass layer with the phosphor (4; 4a) or the material (3a) containing the phosphor (4; 4a) and subjected to the temperature treatment (TB1).

4. Method to a claim 3,
**characterised in that**
the compact, cohesive and low-bubble glass layer is provided in an unheated state and is softened by the temperature treatment (TB1).

5. Method according to any of claims 1 to 4,
**characterised by** the further steps before, during and/or after cooling of the glass material (2a):
c) applying a layer (5) of further glass material to the glass material (2a) treated in step a),
d) applying further phosphor (4; 4b) or a layer containing further phosphor (4; 4b) to a surface (5A) of the further layer (5), wherein the surface (5A) faces away from the glass material (2a) treated in step a), and
e) introducing the further phosphor (4; 4b) into the opposite surface (5A) of the further glass material (2a) by sinking at elevated temperature (T2).

6. Method according to claim 5,
**characterised in that**
the further glass material is applied to the side already covered with phosphor (4; 4a) of the glass material (2a) treated in step a) and is provided in steps d) and e) with a different phosphor (4; 4b) than the glass material (2a) treated in step a).

7. Method according to any of claims 1 to 4,
**characterised by** the further steps before, during and/or after cooling of the glass material (2a):
c) applying further phosphor (4; 4b) or a layer (6) containing further phosphor (4; 4b) to a further, opposite surface (1B) of the glass material (2b) treated in step a), and
d) introducing the further phosphor (4; 4b) into the second, opposite surface by sinking at elevated temperature (T2) .

8. Method according to any of claims 1 to 6,
**characterised in that**
the glass material (2a) used in step a) or c) is a plane-parallel thin glass or ultra-thin glass with a glass thickness of between 5 µm and 1000 µm, preferably between 5 µm and 500 µm, or a piston-shaped glass body (8) with a cavity (9) on one side, or a lens.

9. Conversion element (10) for an optical and/or optoelectronic component (20), wherein the conversion element (10) comprises at least the following:
- A transparent, layered or otherwise shaped glass substrate (1),
- wherein the glass substrate (1) has at least one plane or curved first surface (1A) and a plane or curved second surface (1B) opposite the first surface (1A), between which the glass substrate (1) has a constant or varying layer thickness (d10),
- wherein the conversion element (10) is formed of a glass material (2a) containing phosphor (4; 4a, 4b),
- wherein the phosphor (4; 4a, 4b) is distributed inhomogeneously in the direction of the layer thickness (d10) of the conversion element (10) and
- wherein the concentration of the phosphor (4; 4a, 4b) has a local maximum at a first surface (1A) of the two surfaces (1A, 1B) and decreases towards the second, opposite surface (1B), and wherein
the conversion element (10) is covered with a scattering layer (16) on the second, opposite surface (1B) of the glass substrate (1).

10. Conversion element according to claim 9,
**characterised in that**
the glass material (2a) of the conversion element (10) contains two different phosphors (4; 4a, 4b), of which a first phosphor (4a) is concentrated in the direction of the layer thickness of the conversion element (10) in a first position between both surfaces (1A, 1B), whereas a second phosphor (4b) is concentrated predominantly at a first surface (1A) of both surfaces (1A, 1B) of the conversion element (10) or in a second position lying in the direction of the layer thickness between the first surface (1A) and the first position.

11. Conversion element according to claim 10,
**characterised in that**
the first surface (1A) of the glass substrate (1) is flat or concave in shape and that the distance between the first surface (1B) and the position of the maximum concentration of the second phosphor (4b), measured in the direction of the layer thickness (b10) of the conversion element (10), is less than 1.0 mm, preferably less than 200 µm.

## Revendications

1. Procédé de fabrication d'un élément de conversion (10) pour un composant optique et/ou optoélectronique (20), le procédé comprenant au moins les étapes suivantes:
a) appliquer une substance luminescente (4; 4a) ou un matériau (3a) contenant de la substance luminescente (4; 4a) sur une surface (1A) d'un matériau de verre (2a) transparent, sans substance luminescente et homogène et réalisation d'un traitement thermique (TB1) à une température élevée (T1) supérieure à la température de ramollissement (Tw) du matériau de verre (2a),
dans lequel le matériau de verre (2a) est ramolli de sorte que la substance luminescente (4; 4a) s'enfonce dans le matériau de verre (2a), et
b) refroidir le matériau de verre (2a) conjointement avec la substance luminescente (4; 4a) immergée, et dans lequel le traitement thermique (TB1) du matériau de verre (2a) est d'abord initié avant que la substance luminescente (4; 4a) ne soit appliquée sur la surface (1A) du matériau de verre (2a) ramolli ou au moins chauffé.

2. Procédé selon la revendication 1,
**caractérisé en ce que**
la substance luminescente (4; 4a) ou le matériau (3a) contenant la substance luminescente (4; 4a) est appliqué directement sur la surface (1A) du matériau de verre (2a) par pulvérisation, brossage, pinceau, déposition électrostatique ou de toute autre manière ou comme agent de démoulage sur un moule (22) ou un moule de presse (23) destiné à la mise en forme du matériau de verre.

3. Procédé selon la revendication 1 ou 2,
**caractérisé en ce que**
le matériau de verre (2a) sous forme de couche de verre compacte, cohérente et avec peu de cloque est recouvert de la substance luminescente (4; 4a) ou du matériau (3a) contenant la substance luminescente (4; 4a) et soumis au traitement thermique (TB1).

4. Procédé selon une revendication 3,
**caractérisé en ce que**
la couche de verre compacte, cohésive et peu de cloque est fournie à l'état non chauffé et est ramollie par le traitement thermique (TB1).

5. Procédé selon l'une des revendications 1 à 4,
**caractérisé par** les étapes supplémentaires avant, pendant et/ou après le refroidissement du matériau de verre (2a) :
c) appliquer une couche (5) de matériau de verre supplémentaire sur le matériau de verre (2a) traité dans l'étape a),
d) appliquer une autre substance luminescente (4; 4b) ou une couche contenant une autre substance luminescente (4; 4b) sur une surface (5A) de l'autre couche (5), dans laquelle la surface (5A) est tournée à l'opposé du matériau de verre (2a) traité dans l'étape a), et
e) introduire l'autre substance luminescente (4; 4b) dans la surface opposée (5A) de l'autre matériau de verre (2a) par enfoncement à température élevée (T2).

6. Procédé selon la revendication 5,
**caractérisé en ce que**
l'autre matériau de verre est appliqué sur le côté déjà recouvert de substance luminescente (4; 4a) du matériau de verre (2a) traité à l'étape a) et est pourvu aux étapes d) et e) d'une autre substance luminescente (4; 4b) que le matériau de verre (2a) traité à l'étape a).

7. Procédé selon l'une des revendications 1 à 4,
**caractérisé par** les étapes supplémentaires avant, pendant et/ou après le refroidissement du matériau de verre (2a) :
c) appliquer une autre substance luminescente (4; 4b) ou une couche (6) contenant une autre substance luminescente (4; 4b) sur une autre surface opposée (1B) du matériau de verre (2b) traité dans l'étape a), et
d) introduire l'autre substance luminescente (4; 4b) dans la deuxième surface opposée par enfoncement à température élevée (T2).

8. Procédé selon l'une des revendications 1 à 6,
**caractérisé en ce que**
le matériau de verre (2a) utilisé dans l'étape a) ou c) est un verre mince ou ultra-mince à faces planes et parallèles avec une épaisseur de verre comprise entre 5 µm et 1000 µm, de préférence entre 5 µm et 500 µm, ou un corps de verre (8) en forme de piston avec une cavité (9) sur un côté, ou une lentille.

9. Elément de conversion (10) pour un composant optique et/ou optoélectronique (20), l'élément de conversion (10) comprenant au moins ce qui suit:
- Un substrat de verre transparent, en couches ou de toute autre forme (1),
- dans lequel le substrat de verre (1) présente au moins une première surface plane ou incurvée (1A) et une deuxième surface plane ou incurvée (1B) opposée à la première surface (1A), entre lesquelles le substrat de verre (1) présente une épaisseur de couche (d10) constante ou variable,
- dans lequel ledit élément de conversion (10) est formé d'un matériau de verre (2a) contenant de la substance luminescente (4; 4a, 4b),
- dans lequel la substance luminescente (4; 4a, 4b) est répartie de manière non homogène dans la direction de l'épaisseur de couche (d10) de l'élément de conversion (10) et
- dans lequel la concentration de la substance luminescente (4; 4a, 4b) a un maximum local au niveau d'une première surface (1A) des deux surfaces (1A, 1B) et diminuée vers la seconde surface opposée (1B), et dans lequel
l'élément de conversion (10) est recouvert d'une couche de diffusion (16) sur la deuxième surface opposée (1B) du substrat de verre (1).

10. Elément de conversion selon la revendication 9,
**caractérisé en ce que**
le matériau de verre (2a) de l'élément de conversion (10) contient deux substance luminescente différentes (4; 4a, 4b), dont une première substance luminescente (4a) est concentrée dans le sens de l'épaisseur de couche de l'élément de conversion (10) dans une première position entre les deux surfaces (1A, 1B), tandis qu'une deuxième substance luminescente (4b) est concentrée principalement sur une première surface (1A) des deux surfaces (1A, 1B) de l'élément de conversion (10) ou dans une deuxième position située dans le sens de l'épaisseur de couche entre la première surface (1A) et la première position.

11. Elément de conversion selon la revendication 10,
**caractérisé en ce que**
la première surface (1A) du substrat de verre (1) est de forme plate ou concave et que la distance entre la première surface (1B) et la position de la concentration maximale de la deuxième substance luminescente (4b), mesurée dans la direction de l'épaisseur de couche (b10) de l'élément de conversion (10), est inférieure à 1,0 mm, de préférence inférieure à 200 µm.
